# EUROPEAN PATENT APPLICATION

(11) **EP 4 723 166 A1**
(43) Date of publication of application: **08.04.2026**
(21) Application number: 24205041.7
(22) Date of filing: 07.10.2024
(51) Int. Cl.: H01L 21/78

(54) **METHOD OF PLACING A FEOL COMPONENT ON A TARGET SUBSTRATE**

(71) Applicant: IHP GmbH - Innovations for High Performance Microelectronics / Leibniz-Institut für innovative Mikroelektronik, 15236 Frankfurt (Oder) (DE)
(72) Inventor: ANAND, Ketan, 15236 Frankfurt (Oder) (DE); MAI, Andreas, 15236 Frankfurt (Oder) (DE); LUKOSE, Rasuole, 15236 Frankfurt (Oder) (DE); YAMAMOTO, Yuji, 15236 Frankfurt (Oder) (DE)
(74) Representative: Eisenführ Speiser

(57) **Abstract**

The present invention relates to a method of placing a FEOL component on a target substrate is proposed. The method comprises the steps of:
- providing a semiconductor layer stack comprising along a stacking direction at least a Si substrate, a Si₁₋ₓGeₓ release layer, with x<1, and a Si quasi-active layer, wherein
the Si quasi-active layer comprises at least one Si quasi-active layer structure on which a FEOL component is arranged and which is connected to further structures in the Si quasi-active layer only by means of one or more tethers,
- selectively etching the Si₁₋ₓGeₓ release layer underneath the at least one Si quasi-active layer structure with the FEOL component, and
- picking up the at least one Si quasi-active layer structure with the FEOL component with a transfer device and placing the at least one Si quasi-active layer structure with the FEOL component on a target substrate using the transfer device.

## Description

### TECHNICAL FIELD

The present invention relates to a method of placing a front-end-of-line (FEOL) component on a target substrate. Furthermore, the present invention relates to a semiconductor layer stack intermediate product and to an electronic or optoelectronic device.

### BACKGROUND OF THE INVENTION

There has been an increasing effort to integrate superior electronic and optoelectronic functionalities, e.g., of semiconductor materials such as III-V materials, into well-established silicon (Si)-processing techniques, e.g., in complementary metal-oxide semiconductor (CMOS) or bipolar CMOS (BiCMOS) production lines.

One approach enabling such integration of high quality semiconductor materials with tailored functionalities into Si-based devices such as Si-integrated circuits (IC) uses the micro-transfer printing technique. The general concept of the micro-transfer printing technique is detailed, e.g., in US 2014/0361409 A1. As described *inter alia* by J. Zhang et al., in the research article "III-V-on-Si photonic integrated circuits realized using micro-transfer-printing," APL Photonics, Vol. 4, Nr. 11, S. 110803, Nov. 2019, micro-transfer printing allows for the manipulation of micrometer-sized thin films/thin film devices and enables the transfer of these thin film devices in a massively parallel manner from a source substrate to a target substrate with high alignment accuracy.

Yet, there is still an ongoing and increasing demand for providing further improved techniques, e.g., based on the micro-transfer printing technique, that allow for combining various different functionalities on one device.

### SUMMARY OF THE INVENTION

The present invention is based on the objective to provide an improved method that allows integrating an FEOL component on a target substrate. The present invention is furthermore based on the objective to provide improved electronic and optoelectronic devices, in particular, that have different functionalities such as digital, analog, and/or sensing functionalities combined on the same device.

According to the present invention, a method of placing, preferably integrating, a FEOL component on a target substrate is proposed. The method comprises the steps of:
- providing a semiconductor layer stack comprising along a stacking direction at least a Si substrate, a Si₁₋ₓGeₓ release layer, with x<1, e.g., of x<0.5, and a Si quasi-active layer, which comprises, e.g., is patterned to form, at least one Si quasi-active layer structure on which a FEOL component is arranged, the Si quasi-active layer structure being connected to further structures in the Si quasi-active layer only by means of one or more tethers,
- selectively etching the Si₁₋ₓGeₓ release layer underneath the at least one Si quasi-active layer structure with the FEOL component, and
- picking up the at least one Si quasi-active layer structure with the FEOL component using a transfer device and placing the at least one Si quasi-active layer structure with the FEOL component on a target substrate with the transfer device.

The present invention includes the recognition that there is a steadily increasing demand for providing improved techniques that allow combining different functions such as digital, analog, and/or sensing functionalities on a common target substrate. Yet, fabricating such devices with high crystal quality and resulting high performances by epitaxial crystal growth remains challenging. With the hetero-epitaxy, a promising approach has been established that allows fabricating high crystal quality semiconductor devices on a source substrate, i.e., separately from a target substrate. Only after fabrication of these crystal quality semiconductor devices, these devices are transferred to the target substrate using the micro-transfer printing technique to fabricate the final electronic or optoelectronic device.

With the method according to the present invention, it is possible to arrange a Si quasi-active layer structure on which a FEOL component is positioned onto a target substrate since the Si₁₋ₓGeₓ release layer is selectively released underneath the at least one Si quasi-active layer structure with the FEOL component. Preferably, selectively releasing underneath the at least one Si quasi-active layer structure with the FEOL component is achieved using wet etching. Yet, also other etching techniques such as vapour phase etching could be employed as an alternative or in addition. After etching underneath the Si quasi-active layer structure, the Si quasi-active layer structure remains attached to the remaining structures of the Si quasi-active layer only by means of the one or more tethers. The connection established by the tethers can be mechanically broken when picking up and transferring the Si quasi-active layer structure with the transfer device. When picked up with the transfer device, the Si quasi-active layer structure can be placed onto the target substrate. The FEOL component can be or can comprise one or more of a single heterojunction bipolar transistor (HBT) or a Ge photodiode or the like.

Accordingly, in the method it is preferred that the Si quasi-active layer structure with the FEOL component is picked-up and transferred to the target substrate by means of micro-transfer printing. For example, the transfer device can be a polydimethylsiloxane (PDMS) stamp. In the micro-transfer printing technique, the stamp is brought into contact with the Si quasi-active layer structure with the FEOL component and is then pulled back at a comparatively high velocity. This movement results in a relatively high adhesion strength of the Si quasi-active layer structure with the FEOL component to the stamp, thereby breaking the tethers and attaching the Si quasi-active layer structure with the FEOL component to the stamp. For placing the Si quasi-active layer structure with the FEOL component onto the target substrate, the Si quasi-active layer structure with the FEOL component is arranged onto the target substrate while slowly retracting the stamp. Further details about the picking up a device and placing it onto a target substrate by means of the micro-transfer printing technique are described, e.g., in the above-cited references as well as in EP 4 213 191 A2.

Preferably, in the method, a Si₁₋ₓGeₓ release layer, with x<0.5 is used, with Ge-content which is beneficial for achieving controlled selective etching of the Si₁₋ₓGeₓ release layer underneath the at least one Si quasi-active layer structure with the FEOL component.

Preferably, in the method, selectively etching of the Si₁₋ₓGeₓ release layer is performed by wet etching and/or by vapor-phase etching. Preferably, selectively wet etching the Si₁₋ₓGeₓ release layer is carried out by modified Godbey etchant with 70% HNOs, deionized water and 0.5% HF in a 35:40:10 ratio is used. The modification of the modified Godbey etchant as preferably used in the method described herein lies in a two times dilution. Accordingly, not a 35:20:10 ratio of HNOs, deionized water and HF is used but a ratio of 35:40:10. The effect of this modification is that it is possible to achieve an improvement of the controlled selective lateral wet etching of Si₁₋ₓGeₓ release layer without significant thickness loss of top Si layer thereby maintaining good selectivity. The method is particularly useful for etching a release layer with a comparatively low Ge content of 20% or less such that x < 0.2 in Si₁₋ₓGeₓ. Preferably, selectively vapor-phase etching of Si₁₋ₓGeₓ release layer is carried out with HCl in vapor-phase with H₂ as carrier gas, preferably, in a reduced pressure chemical vapour deposition (RPCVD) reactor. The advantage of selective vapor-phase etching is that it can achieve a comparatively high etch rate with improved selectivity and it can be useful for etching a release layer with a comparatively high Ge content of up to 50% as well such that x < 0.5 in Si₁₋ₓGeₓ.

For example, two step isotropic etching in a reactor can be employed including oxidation with remote He-O₂ plasma and etching with remote NH₃/NF₃/O₂ plasma can be used. Alternatively, wet etching by peracetic acid (CH₃COOH + H₂O₂) and hydrofluoric acid (HF) or a tetramethylammonium hydroxide (TMAH) solution, e.g., a TMAH 5 % solution, can be used. Yet, it is particularly preferred to use selective Si₁₋ₓGeₓ wet etching by a modified Godbey etchant, preferably, with about 70 % HNOs and deionized water as well as about 0.5 % HF, preferably, in a 35:40:10 ratio. Additionally or alternatively, HCl vapor-phase etching with H₂ as carrier gas, may be employed for selective Si₁₋ₓGeₓ etching.

It is preferred that the at least one Si quasi-active layer structure on which a FEOL component is arranged has or is fabricated to have at least one [110]-oriented sidewall. Having at least one [110]-oriented sidewall is preferred because, generally, the lateral etch rate is the highest along [110]-oriented sidewall due to a dependence of etch rate on the crystal orientation which occurs because of anisotropic nature of etching.

Preferably, in the method, the at least one Si quasi-active layer structure on which a FEOL component is arranged has a length in at least one lateral direction between 250 nm and 800 nm, e.g., and may be defined by the equation: Iₓ = 2 (ER_{lateral fitted}) t - 12.406 where ER_{lateral fitted} = 9.093 nm/min; Iₓ = etched lateral Si₁₋ₓGeₓ length from both sides (nm) and t = modified Godbey etch time (min). On the other hand, the length in lateral direction for at least one Si quasi-active layer structure on which a FEOL component is arranged is between 3400 nm and 50000 nm, e.g., and is used for selective HCl vapor-phase etching may be defined by the equation: Iₓ = 2 (ERₗₐₜₑᵣₐₗ) t - 126.43 where ERₗₐₜₑᵣₐₗ = 1957.85 nm/min; Iₓ = etched lateral Si₁₋ₓGeₓ length from both sides (nm) and t = HCl vapor-phase etch time (min). For example, the at least one Si quasi-active layer structure on which a FEOL component can have a rectangular or square shape. For example, the at least one Si quasi-active layer structure on which a FEOL component is arranged can have a length in at least one lateral direction <110> direction of about 800 nm or less for a wet etched sample and about 50 µm or less for a vapor-phase etched sample. The at least one Si quasi-active layer structure can have a quadratic shape or rectangular shape. In particular, the lateral direction for the Si quasi-active layer structure can be selected in dependence on an etching time. Typically, the larger the lateral length of the Si active-layer structure, the longer the etching time should be selected. A particular length should be selected based on the size of the Si quasi active layer (topped with FEOL component) which shall be picked up and placed on the target substrate depending on the application requirement, which in turn leads to selection of corresponding etching time. For example, for modified Godbey etching, 800 nm typically is the maximum lateral length of Si active-layer structure which can be achieved, e.g., by 45 min etching time whereas for vapor-phase etching, 50 µm typically is the maximum lateral length of Si active-layer structure which can be achieved, e.g., by 13 min etching time. Another aspect that may be considered is the minimum depth of release layer "d_{R}" which is the sum of thicknesses of active device layer "d_{A}" and minimum vertical etched layer "l_{y}" (same material as active device) such that d_{R} = dₐ + l_{y} where "l_{y}" depends on vertical etch rate causing thickness loss of top layer during lateral selective etching of Si₁₋ₓGeₓ release layer. For wet-etching, this may be defined by the equation: l_{y} = (ER_{vertical}) t where ER_{vertical} = 0.185 nm/min; l_{y} = minimum vertical etched layer (nm) and t = modified Godbey etch time (min). On the other hand, for vapor-phase etching, this may be defined by the equation: l_{y} = (ER_{vertical}) t where ER_{vertical} = 8.25 nm/min; l_{y} = minimum vertical etched layer (nm) and t = HCl vapor-phase etch time (min).

Preferably, the Si quasi-active layer comprises at least one Si spacer layer structure that is connected to the at least one Si quasi-active layer structure on which a FEOL component is arranged by means of the one or more tethers. The Si spacer layer structure can serve for holding the at least one Si quasi-active layer structure via the tethers on the Si substrate also when the Si₁₋ₓGeₓ release layer is selectively removed underneath the Si quasi-active layer structure. Since the Si₁₋ₓGeₓ release layer is removed selectively underneath the Si quasi-active layer structure, still parts of the Si₁₋ₓGeₓ release layer remain between the at least one Si spacer layer structure and the Si substrate such that the Si spacer layer structure is held onto the Si substrate via the remaining parts of the Si₁₋ₓGeₓ release layer. Thereby, it is possible to break the tethers mechanically to remove the connection between the at least one Si spacer layer structure and the Si quasi-active layer structure on which a FEOL component is arranged using the transfer device. The Si quasi-active layer structure can then be transferred to the target substrate while the Si spacer layer structure remains on the Si substrate. Accordingly, in the method it is preferred that when selectively wet etching or vapor-phase etching the Si₁₋ₓGeₓ release layer, the at least one Si spacer layer structure that is connected to the at least one Si quasi-active layer structure is only partly under-etched. In particular, in the method it is preferred that the Si₁₋ₓGeₓ under the FEOL components on the Si quasi-active layer structure is completely under-etched such that the FEOL component is suspended by the one or more tethers surrounding it whereas the Si₁-ₓGeₓ under the Si spacer layer structure is partially under-etched such that parts of the Si₁-ₓGeₓ release layer still remaining in the Si spacer layer structure and the Si substrate.

For example, for achieving full under-etching of the Si quasi-active layer structure and only partly under-etching of the Si spacer layer structure it is preferred that a lateral length of the at least one Si spacer layer structure is at least twice a lateral length of the at least one Si quasi-active layer structure. That is, preferably, the minimum ratio of a length of the at least one Si quasi-active layer structure and the at least one Si spacer layer structure is 1:2. In the wet-etching method, it is particularly preferred that a lateral length (nm) of the at least one Si spacer layer structure is at least 500 nm, and may be defined as a function of modified Godbey etch time (min) by the equation: Iₓ = 36.372 t - 24.812 and a lateral length (nm) of the at least one Si quasi-active layer structure may be defined as a function of modified Godbey etch time (min) by the equation: Iₓ = 18.186 t - 12.406. On the other hand, in the vapor-phase etching method, it is particularly preferred that a lateral length (nm) of the at least one Si spacer layer structure is at least 6800 nm, and may be defined as a function of HCl vapor-phase etch time (min) by the equation: Iₓ = 7831.4 t - 252.86 and a lateral length (nm) of the at least one Si quasi-active layer structure may be defined as a function of HCl vapor-phase etch time (min) by the equation: Iₓ = 3915.7 t - 126.43.

Preferably, in the method, providing the semiconductor layer stack comprises photolithographic patterning and opening at least one trench around the at least one Si quasi-active layer structure with the FEOL component such that the at least one Si quasi-active layer structure is to the further structures in the Si quasi-active layer only by means of the one or more tethers. For example, trenches in the Si quasi-active layer can be opened by lithographic techniques to form one or more of the at least one Si quasi-active layer structure, the one or more tethers and the at least one Si spacer layer structure. By means of lithography, the positions and dimensions of the at least one Si quasi-active layer structure, the one or more tethers and the at least one Si spacer layer structure can be determined. For example, photolithography patterning and subsequent reactive ion etching could be employed.

Opening at least one trench around the at least one Si quasi-active layer structure with the FEOL component can be achieved by photolithography patterning and opening the trench in form of caskets by two step reactive ion etching including top Si quasi-active layer and underneath Si₁₋ₓGeₓ release layer by CH₃Br/Cl₂/O₂/He+O₂/CF₄ plasma mixture. For example, trenches in the Si quasi-active layer may be opened in such a way that for the wet etched sample, the lateral length of the Si spacer layer structure is about 1600 nm and a lateral length of the Si quasi-active layer is about 800 nm whereas for the vapor-phase etched sample, the lateral length of the Si spacer layer structure is about 100 µm and a lateral length of the Si quasi-active layer is about 50 µm. Thereby, it can be ensured that the lateral length of the Si₁₋ₓGeₓ underneath the Si spacer layer structure is sufficiently more than the lateral length of the Si₁₋ₓGeₓ underneath the Si quasi-active layer structure.

In the method it is possible that providing the semiconductor layer stack comprises that a Si seed layer is arranged between the Si substrate and the Si₁₋ₓGeₓ release layer. One advantage of having a Si seed layer is that it can act as a buffer for accommodating the lattice mismatch between Si substrate and the Si₁₋ₓGeₓ release layer thereby enabling controlled strain transfer from Si substrate below it to the Si₁₋ₓGeₓ release layer above it. Moreover, a Si seed layer may yield a reduction of dislocations and other crystalline defects which can otherwise propagate directly from Si substrate to epitaxially grown Si₁₋ₓGeₓ release layer which in turn provides high quality Si₁₋ₓGeₓ release layer.

In the method, it is preferred that providing the semiconductor layer stack comprises that the Si₁₋ₓGeₓ release layer has at least 50% Si. Additionally, or alternatively, preferably, providing the semiconductor layer stack comprises that the Si₁₋ₓGeₓ release layer has preferably between 10% and 30%, even more preferably between 15% and 20% Ge for wet-etched sample and preferably, between 40% and 50% Ge for vapor-phase etched sample. Having a Ge content of 15% to 20% is particularly preferred when performing selective Si₁-ₓGeₓ wet etching by a modified Godbey etchant and having a Ge content of 40% to 50% is particularly preferred when performing selective Si₁₋ₓGeₓ vapor-phase etching by HCl, to selectively remove the Si₁₋ₓGeₓ release layer underneath the at least one Si quasi-active layer structure with the FEOL component. This is because the etch rate can be controlled in an improved manner, e.g., without significant oxidation or amorphous coverage of etched cavity, when the Ge content is between 15% and 20%, in particular, in case a modified Godbey etchant is used as etching solution. For vapor-phase etching, higher Ge content between 40% and 50% is preferred for faster etch rate of relatively larger Si quasi-active layer lengths.

The present invention also relates to a semiconductor layer stack intermediate product that comprises a semiconductor layer stack comprising along a stacking direction at least a Si substrate, a Si₁₋ₓGeₓ release layer and a Si quasi-active layer. The Si quasi-active layer comprises at least one Si quasi-active layer structure on which a FEOL component is arranged and which is connected to further structures in the Si quasi-active layer, preferably only, by means of one or more tethers. The Si₁₋ₓGeₓ release layer has been removed underneath the at least one Si quasi-active layer structure with the FEOL component. For example, the semiconductor layer stack intermediate product can be fabricated as part of the method for integrating a FEOL component on a target wafer as described herein. Preferably, the Si quasi-active layer comprises at least one Si spacer layer structure that is connected to the at least one Si quasi-active layer structure on which a FEOL component is arranged by means of the one or more tethers. From this semiconductor layer stack intermediate product, the at least one Si quasi-active layer structure on which the FEOL can be picked up with a transfer device using a micro transfer printing technique to transfer the at least one Si quasi-active layer structure on which the FEOL onto target substrate.

The present invention also relates to an electronic or optoelectronic device comprising a target substrate with at least one Si quasi-active layer structure comprising an FEOL component, the at least one Si quasi-active layer structure having a length in at least one lateral direction between 250 nm and 800 nm for wet etched sample whereas between 3 µm and 50 µm for vapor-phase etched sample. In particular, 3.4 µm lateral etching length from both sides can be realised, after 1 min HCl vapor-phase etching. The type of etching employed during fabrication of the electronic or optoelectronic device may be distinguished by virtue of the etched length of release layer. Wet etching by the modified Godbey is suitable for etching in the range of several hundred nanometres. Vapor-phase etching by HCl in a H₂ carrier gas is suitable for etching in the range of several microns. Hence, in case the electronic or optoelectronic device has dimensions in the range of several hundred nanometres this may be indicative that modified Godbey etching has been employed. In case the dimensions of the electronic or optoelectronic device are in the range of several microns may be indicative that HCl vapor-phase etching has been employed. The electronic or optoelectronic device can be fabricated by means of the method for integrating a FEOL component on a target wafer as described herein. For example, the at least one Si quasi-active layer structure comprising the FEOL component could have been picked up with a transfer device from a semiconductor layer stack intermediate product as described herein and transferred to the target substrate for fabricating the electronic or optoelectronic device. The electronic or optoelectronic device can be configured to provide various different functionalities on the same device. For example, the electronic or optoelectronic device can combine different functions such as digital, analog, and/or sensing functionalities on a common target substrate. Digital functionality may be implemented in an FEOL component by means of a digital electronic circuit that can be made from large assemblies of logic gates, e.g., packaged in integrated circuits. Analog functionalities may be implemented in an FEOL component by employing analog circuits, e.g., passive analog circuits comprising resistors, capacitors and inductors or the like and/or active analog circuits also comprising active elements such as transistors. Sensor functionalities in the FEOL component may be implemented by optical sensors such as a photodiode or temperature sensors. Furthermore, the FEOL component may comprise photodetectors, such as photoconductors, charge-coupled devices (CCD), photomultiplier tubes, LED's and PIN diodes depending on the respective field of application. Also pressure sensors and/or gas sensors or biosensors may be used in the FEOL component.

In particular, with method of integrating an FEOL component on a target substrate as described herein, it is possible to realize ultra-thin chiplets smaller than 10 µm. Due to the fact that this approach can be applied to various Si-technologies, with the method described herein it is possible to combine different functions such as digital, analog, sensing, on a common target substrate. For example, it is possible to combine high performance Si₁₋ₓGeₓ-Bi-CMOS with other technology options as photonics, quantum-layers or the like.

It shall be understood that the method of claim 1, the semiconductor layer stack intermediate product of claim 14 and the electronic or optoelectronic device of claim 15 have similar and/or identical preferred embodiments, in particular, as defined in the dependent claims.

It shall be understood that a preferred embodiment of the present invention can also be any combination of the dependent claims or above embodiments with the respective independent claim.

These and other aspects of the invention will be apparent from and elucidated with reference to the embodiments described hereinafter.

### BRIEF DESCRIPTION OF THE DRAWINGS

In the following drawings:
- Figs. 1 to 7:: schematically and exemplary show several different semiconductor layer stack intermediate products, referred to as intermediate products, in a cross-sectional side view that are fabricated when conducting a method of integrating a FEOL component on a target substrate;
- Fig. 8:: schematically and exemplary shows the intermediate product of Fig. 3 in a top view with an added dotted line denoting exemplary the position of the cut for the cross-sectional side views of the intermediate products shown in Figs. 1 to 7;
- Fig. 9:: shows a scanning electron microscopy image of a semiconductor layer stack intermediate product in a cross-sectional view that has been processed by lateral selective Si₁₋ₓGeₓ etching using modified Godbey at a magnification of 15,000; and
- Fig. 10:: shows a scanning electron microscopy image of a semiconductor layer stack intermediate product in a cross-sectional view that has been processed by lateral selective Si₁₋ₓGeₓ etching using HCl vapor-phase at a magnification of 15,000.

### DETAILED DESCRIPTION OF EMBODIMENTS

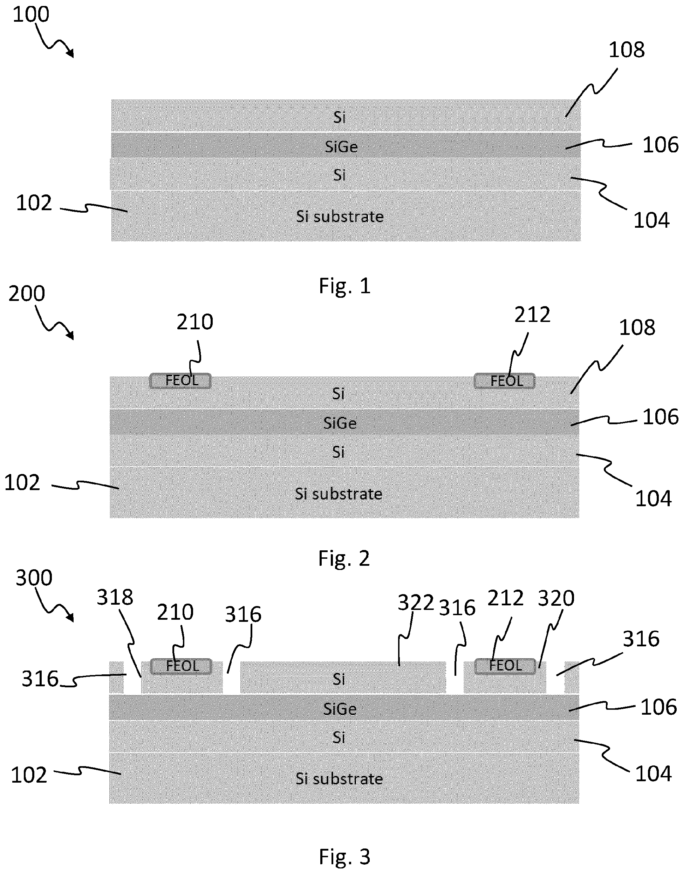

Figure 1 schematically and exemplary shows a semiconductor layer stack intermediate product 100 comprising along a stacking direction a Si substrate 102, an optional Si seed layer 104, a Si₁₋ₓGeₓ release layer 106 and a Si quasi-active layer 108. In this embodiment, the Si substrate 102 has a circular shape and a diameter of 20.32 cm (8 inch wafer). The Si seed layer 104 has a thickness of 50 nm but may have alternatively a thickness of 10 nm to 100 nm. The Si₁₋ₓGeₓ release layer 106 has a Ge content of 20 to 40%, i.e., with x=0.2 to 0.4, resulting in the composition Si_{0.8}Ge_{0.2} to Si_{0.6}Ge_{0.4}. In case a Ge content of 20 to 40% is used in the Si₁₋ₓGeₓ release layer 106, the maximum thickness can be up to 100 nm for 20% Ge and 20 nm for 40% Ge, which may be the critical thickness. The critical thickness can change depending on the Ge content. For example, for 30% Ge in the Si₁-ₓGeₓ release layer there can be a critical thickness of about 35 nm. It is preferred that the Si₁₋ₓGeₓ release layer has a thickness below critical thickness to reduce the formation of misfit dislocations thereby enabling high quality of the epitaxially grown Si₁₋ₓGeₓ release layer.

Alternatively, the Ge content may range between 10% and 50% depending on the application and the etching method to be used. The Si₁₋ₓGeₓ release layer 106 has a thickness of 35 nm for wet etched sample and 10 nm for vapor-phase etched sample, but may alternatively have a thickness of 10 nm to 80 nm. The Si quasi-active layer 108 has a thickness of 50 nm for wet etched sample and 100 nm for vapor-phase etched sample, but may alternatively have a thickness of 10 nm to 300 nm such as 10 nm to 200 nm depending on the FEOL application.

Figure 2 schematically and exemplary shows a semiconductor layer stack intermediate product 200 that has been achieved by FEOL processing of the semiconductor layer stack intermediate product 100 described with reference to figure 1. The FEOL processing results in two FEOL components 210, 212 such as single HBT or a Ge photodiode on top of the Si quasi-active layer 108. The two FEOL components 210, 212 are only to be understood exemplary. Accordingly, it is also possible that there is only one FEOL component or many FEOL components such as more than 10, more than 30, more than 50 or more than 100 FEOL components.

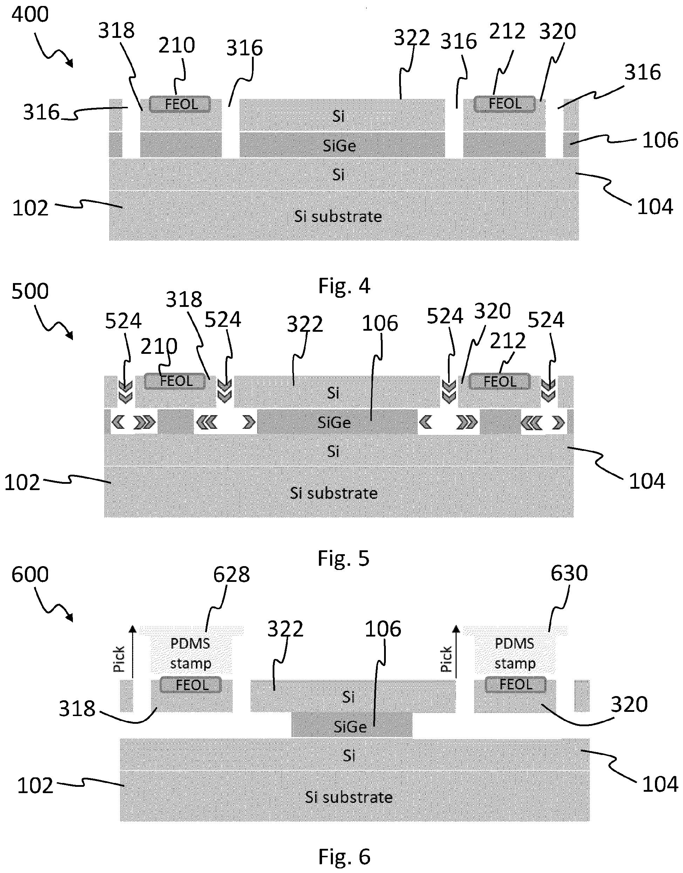

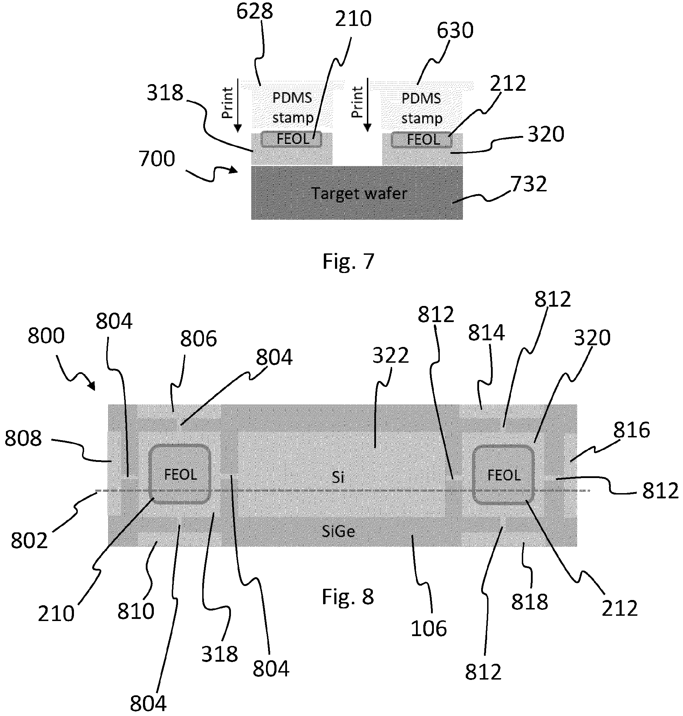

Figures 3 and 4 schematically and exemplary show a semiconductor layer stack intermediate products 300, 400, respectively, that have been achieved by fabricating a mesa structure with [110]-oriented sidewalls and tethers 804 (the tethers are shown in the top view depicted in figure 8) in the Si quasi-active layer 108 of the semiconductor layer stack intermediate product 200 described with reference to figure 2. The mesa structure has been realised by photolithography patterning and opening the several trenches 316 in form of caskets by two step reactive ion etching. The two-step reactive ion etching includes top Si quasi-active layer etching resulting in semiconductor layer stack intermediate product 300 as shown in figure 3 and underneath Si₁₋ₓGeₓ release layer etching by employing a CH₃Br/Cl₂/O₂/He+O₂/CF₄ plasma mixture resulting in semiconductor layer stack intermediate product 400 as shown in figure 4. As a result, the mesa structure formed in the Si quasi-active layer 108 includes Si quasi-active layer structures 318, 320 each comprising one of the FEOL components 210, 212, respectively, and a rectangular Si spacer layer structure 322 arranged between Si quasi-active layer structures 318, 320. The Si quasi-active layer structures 318, 320 and the Si spacer layer structure 322 are connected to each other by means of tethers that are shown in figure 8. In this embodiment, the Si quasi-active layer structures 318, 320 have a square shape with about 800 nm lateral lengths for wet etched sample whereas 50 µm lateral lengths for vapor-phase etched sample and the Si spacer layer structure 322 also has a rectangular shape however with about 1600 nm lateral lengths for wet etched sample whereas 100 µm lateral lengths for vapor-phase etched sample. Alternatively, Si quasi-active layer structures with lateral lengths of less than 800 nm could be fabricated, e.g., between 250 nm and 800 nm for wet etched sample whereas Si quasi-active layer structures with lateral lengths of 50 µm could be fabricated, e.g., between 3 µm, e.g., at least 3.4 µm, and 50 µm for vapor-phase etched sample. Also other shapes than square shapes could be used. Preferably, Si quasi-active layer structures and Si spacer layer structures in the Si quasi-active layer 108 are fabricated such that a lateral length of the Si spacer layer structures is at least twice the lateral length of the Si quasi-active layer structures.

Figure 5 schematically and exemplary shows a semiconductor layer stack intermediate product 500 that has been achieved by performing selective Si₁₋ₓGeₓ wet etching and vapor-phase etching of the semiconductor layer stack intermediate product 400 described with reference to figure 4. By means of the selective Si₁₋ₓGeₓ wet etching and vapor-phase etching, the Si₁₋ₓGeₓ release layer 106 underneath the Si quasi-active layer structures 318, 320 with the FEOL components 210, 212 is completely removed while the Si₁₋ₓGeₓ release layer 106 underneath the Si spacer layer structure 322 is only partly removed, as indicated by the arrows 524 in the trenches 316.

In this embodiment, selective Si₁₋ₓGeₓ wet etching may be achieved by dipping the semiconductor layer stack intermediate product 400 described with reference to figure 4 into a modified Godbey etchant bath with 70 % HNOs and deionized water as well as about 0.5 % HF, preferably, in a 35:40:10 ratio for about 45 min such that the etchant enters from the casket trenches 316 and starts etching the Si₁₋ₓGeₓ release layer 106 from all lateral sides. On the other hand, the selective Si₁₋ₓGeₓ vapor-phase etching may be achieved by passing HCl vapours in H₂ carrier gas into the semiconductor layer stack intermediate product 400 described with reference to figure 4 for about 1.5 min such that the etchant/vapor enters from the casket trenches 316 and starts etching the Si₁₋ₓGeₓ release layer 106 from all lateral sides. The trenches 316 have been opened in such a way that the lateral length of the Si₁₋ₓGeₓ underneath the Si spacer layer structure 322 is sufficiently more than a lateral length of the Si₁₋ₓGeₓ underneath the Si quasi-active layer structures 318, 320. The etching time of about 45 min may provide an etch rate of about 9 nm/min when using a modified Godbey etchant for a pseudomorphic Si_{0.8}Ge_{0.2} layer. After 45 min, the Si_{0.8}Ge_{0.2} under the FEOL components 210, 212 on Si quasi-active layer structures 318, 320 have been completely under-etched and the FEOL components 210, 212 are suspended by tethers surrounding it whereas the Si_{0.8}Ge_{0.2} under the Si spacer layer structure 322 has been partially under-etched and still remains between the Si spacer layer structure 322 and the Si seed layer 104 (if present) and otherwise between the Si spacer layer structure 322 and the Si substrate 102. The etching time of about 13 min may provide an etch rate of about 1957.85 nm/min when using a HCl vapor-phase etchant for a pseudomorphic Si_{0.6}Ge_{0.4} layer. After 13 min, the Si_{0.8}Ge_{0.2} under the FEOL components 210, 212 on Si quasi-active layer structures 318, 320 may have been completely under-etched and the FEOL components 210, 212 may be suspended by tethers surrounding it whereas the Si_{0.8}Ge_{0.2} under the Si spacer layer structure 322 has been partially under-etched and still remains between the Si spacer layer structure 322 and the Si seed layer 104 (if present) and otherwise between the Si spacer layer structure 322 and the Si substrate 102.

Alternatively, to a selective Si₁₋ₓGeₓ wet etching with a modified Godbey etchant and/or vapor-phase etching with HCl as described herein, it is also possible for two step isotropic etching including an oxidation step with remote He-O₂ plasma and an etching step including remote NH₃/NF₃/O₂ plasma. Yet, alternatively, selective Si₁₋ₓGeₓ wet etching can be achieved using peracetic acid, e.g., CH₃COOH and H₂O₂ as well as HF.

Figure 6 schematically and exemplary shows a semiconductor layer stack intermediate product 600 that has been achieved by arranging PDMS stamps 628, 630 on the Si quasi-active layer structures 318, 320 of the semiconductor layer stack intermediate product 500 described with reference to figure 5. With the PDMS stamps 628, 630, it is possible to selectively pick up the FEOL components 210, 212 on Si quasi-active layer structures 318, 320 and to print them on a target substrate 732 with the PDMS stamps 628, 630 as shown in figure 7. The transfer of the Si quasi-active layer structures 318, 320 from the semiconductor layer stack intermediate product 500 onto the target substrate 732 is shown in figure 7 and is achieved using micro-transfer printing. As a result of the method of integrating a FEOL component on a target substrate, a target substrate 732 with Si quasi-active layer structures 318, 320 comprising FEOL components 210, 212, respectively, as schematically and exemplary in figure 7 is obtained. The target substrate 732 with Si quasi-active layer structures 318, 320 comprising FEOL components 210, 212 may form an electronic or optoelectronic device 700.

Figure 8 schematically and exemplary shows the intermediate product 300 of Fig. 3 in a top view with an added dotted line 802 denoting exemplary the position of the cut for the cross-sectional side views of the intermediate products shown in figures 1 to 6. In the top view of figure 8, it can be seen that the Si quasi-active layer structure 318 is connected via tethers 804 to adjacent Si spacer layer structure 322, 806, 808, 810 and the Si quasi-active layer structure 320 is connected via tethers 812 to adjacent Si spacer layer structure 322, 814, 816, 818.

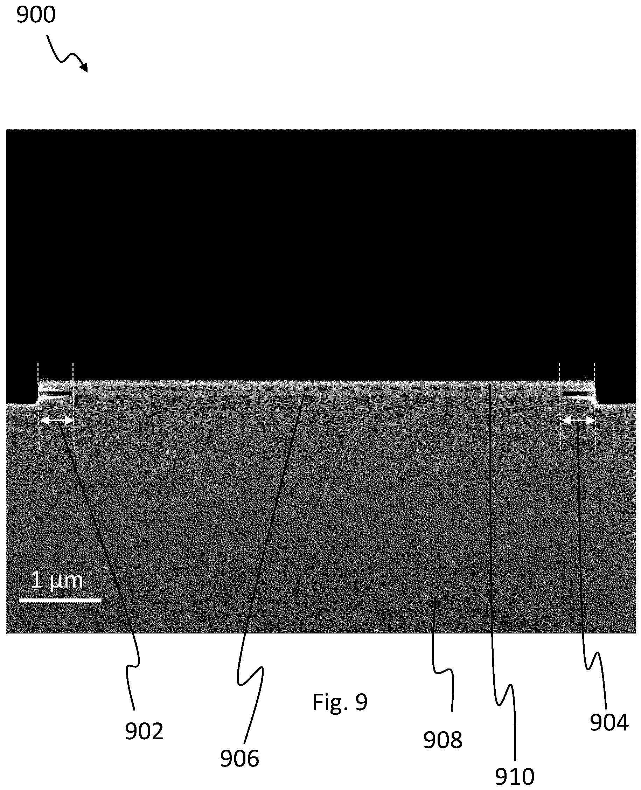

Figure 9 shows a scanning electron microscopy of a semiconductor layer stack intermediate product 900 in a cross-sectional view that has been processed by lateral selective Si₁₋ₓGeₓ etching using modified Godbey at a magnification of 15,000. The modified Godbey wet etching has been performed with an etching time of 45 min and an etching rate of 9.1 nm/min. An etched length 902, 904 from each lateral side is approximately 411 nm. The selectively etched Si₁₋ₓGeₓ release layer 906 has a Ge content of about 18.5% and a thickness of about 38.5 nm. The Si₁₋ₓGeₓ release layer 906 is arranged on a Si substrate 908. Arranged on top of the Si₁₋ₓGeₓ release layer 906 there is a Si quasi-active layer structure 910.

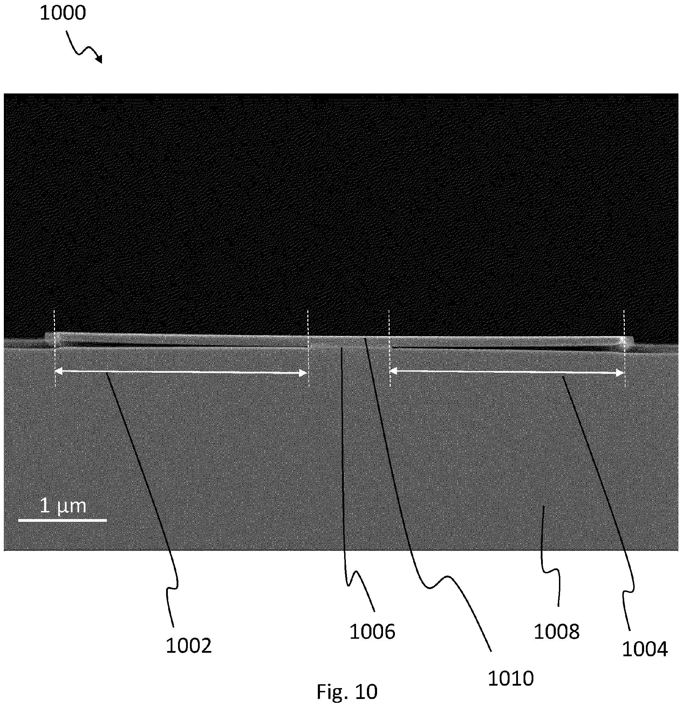

Figure 10 shows a scanning electron microscopy image of a semiconductor layer stack intermediate product 1000 in a cross-sectional view that has been processed by lateral selective Si₁₋ₓGeₓ etching using HCl vapor-phase at a magnification of 15,000. The HCl vapor-phase etching has been carried out with an etching time of about 1.5 min and an etching rate of about 1957.8 nm/min. The etched length 1002, 1004 on each lateral side is about 2936.8 nm. The selectively etched Si₁₋ₓGeₓ release layer 1006 has a Ge content of about 40% and a thickness of approximately 10 nm. The Si₁₋ₓGeₓ release layer 1006 is arranged on a Si substrate 1008. Arranged on top of the Si₁₋ₓGeₓ release layer 1006 there is a Si quasi-active layer structure 1010.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

Any reference signs in the claims should not be construed as limiting the scope.

## Claims

1. A method of placing a front-end-of-line, hereinafter called FEOL, component on a target substrate, the method comprising the steps of:
- providing a semiconductor layer stack comprising along a stacking direction at least a Si substrate, a Si₁₋ₓGeₓ release layer, with x<1, and a Si quasi-active layer, wherein
the Si quasi-active layer comprises at least one Si quasi-active layer structure on which a FEOL component is arranged and which is connected to further structures in the Si quasi-active layer only by means of one or more tethers,
- selectively etching the Si₁₋ₓGeₓ release layer underneath the at least one Si quasi-active layer structure with the FEOL component, and
- picking up the at least one Si quasi-active layer structure with the FEOL component with a transfer device and placing the at least one Si quasi-active layer structure with the FEOL component on a target substrate using the transfer device.

2. The method according to claim 1, wherein for selectively wet etching the Si₁₋ₓGeₓ release layer, a modified Godbey etchant with HNOs, deionized water and HF in a 35:40:10 ratio is used.

3. The method according to at least one of the preceding claims, wherein selectively etching the Si₁₋ₓGeₓ release layer is carried out using HCl in vapor-phase with H₂ as carrier gas.

4. The method according to at least one of the preceding claims, wherein the at least one Si quasi-active layer structure on which a FEOL component is arranged has at least one [110]-oriented sidewall.

5. The method according to at least one of the preceding claims, wherein the at least one Si quasi-active layer structure on which a FEOL component is arranged has a length in at least one lateral direction between 250 nm and 800 nm in case selectively etching is performed by wet etching or in case selectively etching is performed by vapor-phase etching between 3 µm and 50 µm.

6. The method according to at least one of the preceding claims, wherein the Si quasi-active layer comprises at least one Si spacer layer structure that is connected to the at least one Si quasi-active layer structure on which a FEOL component is arranged by means of the one or more tethers.

7. The method according to claim 6, wherein when selectively wet etching and vapor-phase etching, the Si₁₋ₓGeₓ release layer, the at least one Si spacer layer structure that is connected to the at least one Si quasi-active layer structure is only partly under etched.

8. The method according to claim 6 or 7, wherein a lateral length of the at least one Si spacer layer structure is at least twice a lateral length of the at least one Si quasi-active layer structure.

9. The method according to claim 8, wherein a lateral length of the at least one Si spacer layer structure is at least 500 nm for wet etched sample whereas at least 6.8 µm for vapor-phase etched sample and/or a lateral length of the at least one Si quasi-active layer structure is at least 250 nm for wet etched sample whereas at least 3 µm for vapor-phase etched sample.

10. The method according to at least one of the preceding claims, wherein providing the semiconductor layer stack comprises photolithographic patterning and opening at least one trench around the at least one Si quasi-active layer structure with the FEOL component such that the at least one Si quasi-active layer structure is to the further structures in the Si quasi-active layer only by means of the one or more tethers.

11. The method according to at least one of the preceding claims, wherein providing the semiconductor layer stack comprises that a Si seed layer is arranged between the Si substrate and the a Si₁₋ₓGeₓ.

12. The method according to at least one of the preceding claims, wherein providing the semiconductor layer stack comprises that the Si₁₋ₓGeₓ release layer has between 15% and 20% Ge for wet etched sample whereas between 30% and 50% for vapor-phase etched sample.

13. The method according to at least one of the preceding claims, wherein the Si quasi-active layer structure with the FEOL component is picked-up and transferred to the target substrate by means of micro-transfer printing.

14. A semiconductor layer stack intermediate product comprising:
- a semiconductor layer stack comprising along a stacking direction at least a Si substrate, a Si₁₋ₓGeₓ release layer and a Si quasi-active layer,
wherein the Si quasi-active layer comprises at least one Si quasi-active layer structure on which a FEOL component is arranged and which is connected to further structures in the Si quasi-active layer only by means of one or more tethers, and
wherein the Si₁₋ₓGeₓ release layer has been removed underneath the at least one Si quasi-active layer structure with the FEOL component.

15. An electronic or optoelectronic device comprising a target substrate with at least one Si quasi-active layer structure comprising an FEOL component, the at least one Si quasi-active layer structure having a length in at least one lateral direction of 250 nm to 800 nm for wet etched sample whereas that of 3 µm to 50 µm for vapor-phase etched sample.
